# EUROPEAN PATENT APPLICATION

(11) **EP 0 901 228 A2**
(43) Date of publication of application: **10.03.1999**
(21) Application number: 98306476.7
(22) Date of filing: 13.08.1998
(51) Int. Cl.: H03K 17/567, H03K 17/691, H03K 17/693

(54) **Driver circuits**

(30) Priority: 03.09.1997 GB 9718556
(71) Applicant: Mitel Semiconductor Limited, Swindon, Wiltshire SN2 2QW (GB)
(72) Inventor: Williams, Barry Wayne, Colinton, Edinburgh, EH13 0HD (GB); McNeill, John Neville, Edinburgh, EH9 1NW (GB)
(74) Representative: Hoste, Colin Francis

(57) **Abstract**

A driver circuit has a number of transformers, the primary windings of which have a common terminal 38. A transistor arrangement 31 provides a low impedance output signal on the terminal 38 which is in antiphase to the clock signal applied to the terminal 45. Thus, one connection of the primary coil of each of pulse transformers 12 - 17 is always driven. The other connection of the primary coil of the pulse transformer is connected to the output of its respective tri-state gate 24 - 29 by way of its respective primary drive output terminal 39 - 44. The gates 24 - 29 are each operable to provide on their output terminal either a signal which follows the clock signal, in the case of a control signal applied to the respective control input terminal 32 - 37 being high, or a high impedance or "tri-state" output in the case of the control signal being low.

## Description

The present invention relates to driver circuits and, more particularly, to driver circuits suitable for driving semiconductor switch devices.

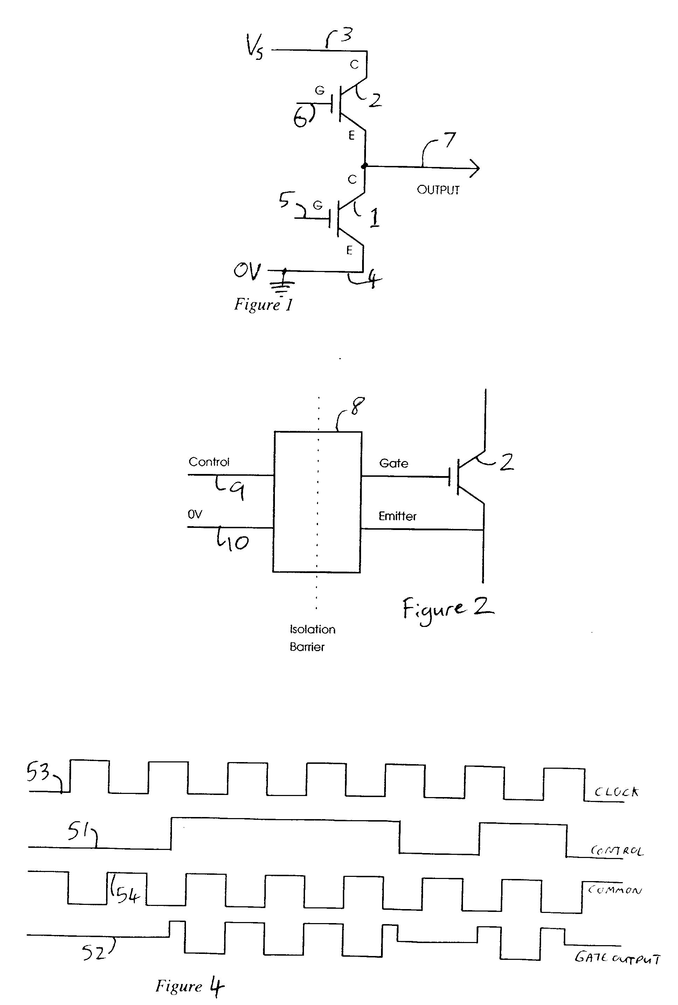

Motors and other actuating drivers are often driven by power circuits comprising Insulated Gate Bipolar Transistors (IGBTs) or Metal Oxide Semiconductor Field Effect Transistors (MOSFETs). These power circuits often involve a Half Bridge configuration, such as that shown in Figure 1.

Referring to Figure 1, first and second IGBTs 1, 2 are shown having their main current paths connected in series between a supply voltage rail 3 and a ground rail 4. Leads 5 and 6, connected to the gate electrodes of IGBTs 1 and 2 respectively, have control voltages applied thereto by external circuitry (not shown) so that only one of the IGBTs 1 and 2 is conducting at any one time. This causes an output lead 7 to show a low impedance output at either supply potential or ground potential, dependent on which of the IGBTs 1 and 2 is conducting at that time.

The IGBTs 1 and 2 are controlled to conduct current through their main current path by the application of a 15V potential across their emitter and gate electrodes. With the IGBT 1 this is achieved by the simple application of a 15V supply to the terminal 5, referenced to the ground rail 4. Control of the IGBT 2 is problematic because, in order to control its gate electrode to be either at the potential of its emitter or 15V higher, circuitry able to apply potentials of the order of Vₛ is required. This can often be hundreds of volts above ground potential.

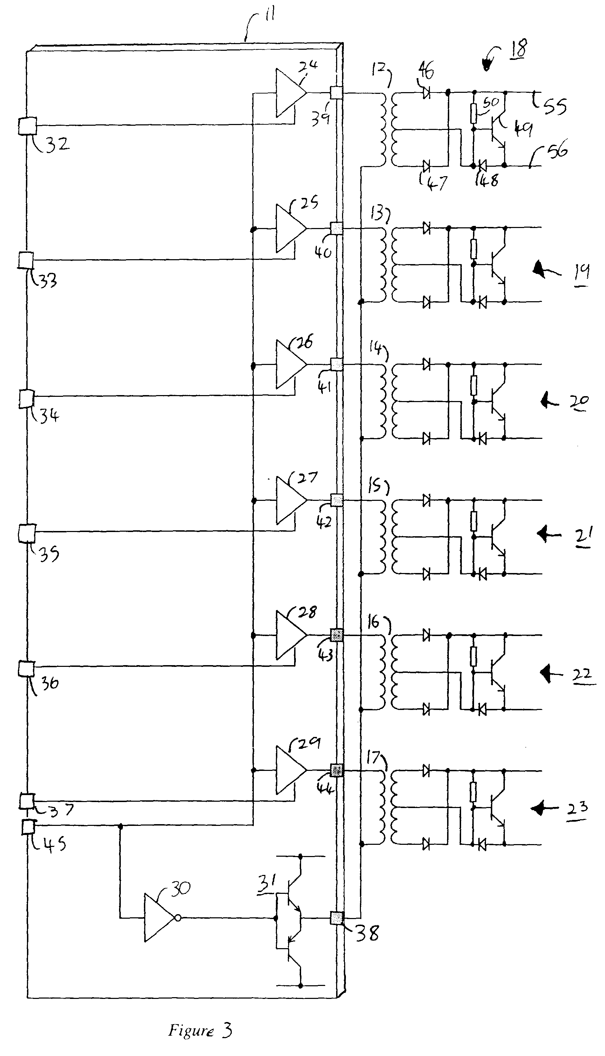

The technique usually employed to control these devices is to create some form of electrical isolation between the gate control electronics and the emitter of the IGBT, as is shown schematically in Figure 2.

In this figure, isolation means 8 are employed to apply the same or a similar voltage across the gate and emitter electrodes of IGBT 2 as is applied across the control and ground electrodes 9 and 10 respectively.

Driver circuits often have to provide isolation of hundreds of volts between control circuitry and the semiconductor switch device being driven. This has often proven to be a problem in the prior art.

In accordance with a first aspect of the present invention, there is provided a driver circuit for driving a semiconductor switch device comprising: a pulse transformer including a primary coil having first and second connection electrodes; means to apply continuously a first voltage signal derived from a clock signal to the first connection electrode; and gate means connected to the second connection electrode and controllable either to allow or to prevent current flow in the primary coil, in dependence on a control signal.

Preferably said gate means comprises a tri-state gate controllable either to apply a second voltage signal, derived from the clock signal and antiphase to the first voltage signal, or to present a high impedance to the second connection electrode, in dependence on the control signal.

The first voltage signal may be derived from the clock signal by a logic device, and applied to the first connection electrode by way of a transistor arrangement. The logic device may comprises an inverter gate and the transistor means comprise a push-pull transistor arrangement.

This provides a reliable, simple and inexpensive arrangement which is able to provide required current levels when the transformer is driven without undergoing unnecessary stressing when not driven.

None of the above arrangements require circuitry controlled to drive opposite coil connections with quasi-complimentary signals only when an output is desired, and thus can exhibit increased reliability and increased performance through eliminating the possibility of mismatch of take-up times in the generation of these complimentary signals. Also, fewer components can be used than in the case where quasi complementary signals are generated, resulting in reduced cost and complexity.

In accordance with a second aspect of the present invention, there is provided a driver circuit for driving a plurality of semiconductor switch devices comprising at least two pulse transformers each including a primary coil having first and second connection electrodes; driving means operable to apply continuously a first voltage signal, derived from a clock signal, to each of said first connection electrodes; and gate means associated with each of said second connection electrodes, each independently controllable either to allow or to prevent current flow in the primary coil of respective transformers, in dependence on respective control signals.

Preferably said first voltage signal is derived from the clock signal by a logic device, and applied to said first connection electrodes by way of a push-pull transistor driving means. The logic device may comprise an inverter gate.

Preferably said gate means each comprise a tri-state gate controllable either to apply a second voltage signal, derived from the clock signal and antiphase to the first voltage signal, or to present a high impedance to, the respective second connection electrode, in dependence on their respective control signal.

These arrangements can provide a driver circuit usable in applications where multiple IGBTs, MOSFETs and the like are required having a reduced component count and, if integrated onto a single circuit, a lower pin count than provided by known drive circuits. This can allow a reduction in manufacturing cost, improved yield and improved circuit reliability.

In accordance with a third aspect of the present invention, there is provided a power circuit including a driver circuit for driving a semiconductor switch device of the power circuit, the driver circuit comprising: a pulse transformer including a primary coil having first and second connection electrodes; means to apply continuously a first voltage signal derived from a clock signal to the first connection electrode; and gate means connected to the second connection electrode and controllable either to allow or to prevent current flow in the primary coil, in dependence on a control signal.

In accordance with a fourth aspect of the present invention, there is provided a power circuit including a driver circuit for driving a plurality of semiconductor switch devices of the power circuit, the driver circuit comprising at least two pulse transformers each including a primary coil having first and second connection electrodes; driving means operable to apply continuously a first voltage signal, derived from a clock signal, to each of said first connection electrodes; and gate means associated with each of said second connection electrodes, each independently controllable either to allow or to prevent current flow in the primary coil of respective transformers, in dependence on respective control signals.

An embodiment of the present invention will now be described, by way of example only, with reference to the accompanying drawings, of which:
Figure 1 shows a known half bridge circuit;
Figure 2 shows schematically the isolation of an IGBT from its control electronics;
Figure 3 shows a driver circuit in accordance with the present invention; and
Figure 4 shows an exemplary timing diagram.

Referring to Figure 3, a driver circuit in accordance with the present invention is shown comprising a conditioning circuit 11, pulse transformers 12 - 17 and secondary conditioning circuits 18 - 23.

The conditioning circuit 11 comprises tri-state gates 24 - 29, an invertor 30, a push-pull transistor arrangement 31, control input terminals 32 - 37, a common output terminal 38, primary drive output terminals 39 - 44 and a clock input terminal 45.

Each of the secondary conditioning circuits 18 - 23 controls respective ones of the six IGBTs (not shown) used in the control of a three-phase motor (not shown). With the operation of each of the six arms of the drive circuit shown in this figure being substantially the same, the operation of only one such arm 32, 24, 39, 12, 18 and the common circuitry 45, 30, 31 and 38 need to be described for the present invention to be understood.

In operation, the push-pull transistor arrangement 31 provides a low impedance output signal on the common output terminal 38. This signal is antiphase to the clock signal applied to the terminal 45, by virtue of the invertor 30, which is preferably a square wave signal of 2 MHz. Thus, one connection of the primary coil of the pulse transformer 12 is always driven, along with each of the other pulse transformers 13 - 17. The other connection of the primary coil of the pulse transformer 12 is connected to the output of the tri-state gate 24 by way of the primary drive output terminal 39 of the conditioning circuit 11. This gate 24 is operable to provide on its output terminal either a signal which follows the clock signal, in the case of a control signal applied to the control input terminal 32 being high, or a high impedance or "tri-state" output in the case of the control signal being low. Thus the tri-state gate 24 co-operates with the common circuitry 45, 30, 31, 38 to cause one of a 2 MHz square wave signal and no signal at all to be conducted by the primary coil of pulse transformer 12, dependent on the signal applied to the control input terminal 32. This arrangement minimises DC current flow in the primary coil of the transformer 12. An exemplary timing diagram is shown in Figure 4.

Referring to Figure 4, it can easily be seen that only when the control signal 51 is high does the signal 52 on the output terminal 39 contain any non-zero frequency components. It can also be easily seen that, in this condition, the signal 52 follows the clock signal 53 and is antiphase to the signal 54 on the common output terminal 38.

Referring back to Figure 3, secondary conditioning circuit 18 comprises three rectifying diodes 46 - 48, an npn transistor 49 and a resistor 50. In use, an IGBT (not shown) will have its gate electrode connected to the lead 55 and its emitter electrode connected to the lead 56.

The pulse transformer 12 will generally have a characteristic such as to pass signals having frequencies in the range of 3 kHz to 10 MHz. Thus the 2 MHz clock signal applied to its primary coil will appear largely unchanged at its secondary coil, although it will have been subjected to a limited amount of "rounding". The connection of the cathode of the diode 48 to a central tap of the secondary coil of pulse transformer 2 and the connection of the anodes of the diodes 46 and 47 to the opposite ends of this coil provides de rectification with the lead 55 essentially being made positive with respect to the lead 56. Thus the IGBT (not shown) connected to these leads will be switched on.

When the transformer 12 is energised, the diode 48 is forward biased and thus keeps the transistor 49 switched off by holding its base negative with respect to its emitter. Also, voltage spikes caused by the switching of rectifying diodes 46 to 48 are smoothed by the gate capacitance of the IGBT itself. It has been found that for optimised operation, the pulse transformer 12 is preferably a 3:1 step-up transformer and is driven at 5 volts and only a few 10's of milliamps. This allows the use of off-the-shelf tri-state gates operating at normal logic voltages whilst still providing the 15 V driving signal to the IGBT. The scale of the current should be a trade-off between sufficiently high current to keep the gate capacitance charged enough to cause the IGBT to conduct properly and sufficiently small to allow rapid discharging of the gate capacitance, to minimise the time the IGBT spends switching off.

When the control signal applied to the terminal 32 goes low, the gate 24 sends its output tri-state, causing de-energisation of the pulse transformer 12. Thus, the diode 48 will cease to be forward biased and the potential difference between the leads 55 and 56 will cause the transistor 49 to be switched on, discharging the IGBT gate through the collector-emitter path of the transistor 49. This arrangement thus provides effective discharging of the IGBT gate electrode and minimises the time the IGBT spends in transition between its on and off states. Thus, power dissipation caused in the switching of the IGBT is minimised. The connection of the transistor 49 also eliminates the need for an external power supply to remove stored charge from the gate capacitance.

Although a centre tapped transformer allowing full wave rectification has been used in the figure 3 example, it will be understood that a half-wave rectifier circuit could be used in its place. This would allow the use of less complex transformers though would require special consideration in the design of the secondary conditioning circuitry.

The embodiment shown in Figure 3 provides driving circuitry for six semiconductor switch devices which may be used, for example in a three-phase motor driving arrangement. As shown, one connection on the primary coil of each of the pulse transformer 12 - 17 is connected to the common output terminal 38. This arrangement allows a reduced component count, and pin count on the conditioning circuit 11, than is achieved by the use of separate driving means for each connection of each pulse transformer primary coil. The transistor push-pull arrangement 31 obviously must have a higher current rating than one used to drive a single pulse transformer though the rating need only increase threefold because only three semiconductor switch devices need be switched on at any one time. Thus the arrangement shown is advantageous in requiring fewer components, thereby allowing improved yield in integrated manufacture, an associated reduction in cost and improved reliability.

Although the invention has been described with six driver circuits used to control six semiconductor switch devices in a three phase application, the scope of the present invention is not limited to such, it being equally applicable to applications where only a single semiconductor switch need be controlled as those in which many such devices are involved.

## Claims

1. A driver circuit for driving a semiconductor switch device comprising: a pulse transformer including a primary coil having first and second connection electrodes; means to apply continuously a first voltage signal derived from a clock signal to the first connection electrode; and gate means connected to the second connection electrode and controllable either to allow or to prevent current flow in the primary coil, in dependence on a control signal.

2. A driver circuit in accordance with Claim 1 in which said gate means comprises a tri-state gate controllable either to apply a second voltage signal, derived from the clock signal and antiphase to the first voltage signal, or to present a high impedance to the second connection electrode, in dependence on the control signal.

3. A driver circuit in accordance with Claim 1 or Claim 2 in which the first voltage signal is derived from the clock signal by a logic device, and applied to the first connection electrode by way of a transistor arrangement.

4. A driver circuit in accordance with Claim 3 in which the logic device comprises an inverter gate and the transistor means comprises a push-pull transistor arrangement.

5. A driver circuit for driving a plurality of semiconductor switch devices comprising at least two pulse transformers each including a primary coil having first and second connection electrodes; driving means operable to apply continuously a first voltage signal, derived from a clock signal, to each of said first connection electrodes; and gate means associated with each of said second connection electrodes, each independently controllable either to allow or to prevent current flow in the primary coil of respective transformers, in dependence on respective control signals.

6. A driver circuit in accordance with Claim 5 in which said first voltage signal is derived from the clock signal by a logic device, and applied to said first connection electrodes by way of a push-pull transistor driving means.

7. A driver circuit in accordance with Claim 6 in which the logic device comprises an inverter gate.

8. A driver circuit in accordance with any of Claims 5 to 7 in which said gate means each comprise a tri-state gate controllable either to apply a second voltage signal, derived from the clock signal and antiphase to the first voltage signal, or to present a high impedance to, the respective second connection electrode, in dependence on their respective control signal.

9. A driver circuit in accordance with any of Claims 1 to 4 and any of Claims 5 to 8.

10. A power circuit including a driver circuit for driving a semiconductor switch device of the power circuit, the driver circuit comprising: a pulse transformer including a primary coil having first and second connection electrodes; means to apply continuously a first voltage signal derived from a clock signal to the first connection electrode; and gate means connected to the second connection electrode and controllable either to allow or to prevent current flow in the primary coil, in dependence on a control signal.14.

11. A power circuit in accordance with Claim 10 in which said gate means comprises a tri-state gate controllable either to apply a second voltage signal, derived from the clock signal and antiphase to the first voltage signal, or to present a high impedance to the second connection electrode, in dependence on the control signal.

12. A power circuit in accordance with Claim 10 or Claim 11 in which the first voltage signal is derived from the clock signal by a logic device, and applied to the first connection electrode by way of a transistor arrangement.

13. A power circuit in accordance with Claim 12 in which the logic device comprises an inverter gate and the transistor means comprises a push-pull transistor arrangement.

14. A power circuit including a driver circuit for driving a plurality of semiconductor switch devices of the power circuit, the driver circuit comprising at least two pulse transformers each including a primary coil having first and second connection electrodes; driving means operable to apply continuously a first voltage signal, derived from a clock signal, to each of said first connection electrodes; and gate means associated with each of said second connection electrodes, each independently controllable either to allow or to prevent current flow in the primary coil of respective transformers, in dependence on respective control signals.

15. A power circuit in accordance with Claim 14 in which said first voltage signal is derived from the clock signal by a logic device, and applied to said first connection electrodes by way of a push-pull transistor driving means.

16. A power circuit in accordance with Claim 15 in which the logic device comprises an inverter gate.

17. A power circuit in accordance with any of Claims 14 to 16 in which said gate means each comprise a tri-state gate controllable either to apply a second voltage signal, derived from the clock signal and antiphase to the first voltage signal, or to present a high impedance to, the respective second connection electrode, in dependence on their respective control signal.
